# EUROPÄISCHE PATENTSCHRIFT

(11) **EP 3 737 853 B1**
(45) Veröffentlichungstag und Bekanntmachung des Hinweises auf die Patenterteilung: **23.07.2025**
(21) Anmeldenummer: 19700582.0
(22) Anmeldetag: 11.01.2019
(51) Int. Cl.: F02N 11/08, F02N 11/10, G01R 31/36, H01M 10/48

(54) **ENERGIESPEICHERVORRICHTUNG, KRAFTFAHRZEUG BZW. ÜBERWACHUNGSSYSTEM MIT EINER SOLCHEN ENERGIESPEICHERVORRICHTUNG UND VERWENDUNG EINER SOLCHEN ENERGIESPEICHERVORRICHTUNG**
ENERGY STORAGE DEVICE, MOTOR VEHICLE OR MONITORING SYSTEM COMPRISING SUCH AN ENERGY STORAGE DEVICE, AND USE OF SUCH AN ENERGY STORAGE DEVICE
DISPOSITIF D'ACCUMULATION D'ÉNERGIE, VÉHICULE AUTOMOBILE OU SYSTÈME DE SURVEILLANCE MUNI DUDIT DISPOSITIF D'ACCUMULATION D'ÉNERGIE, ET UTILISATION DUDIT DISPOSITIF D'ACCUMULATION D'ÉNERGIE

(30) Priorität: 11.01.2018 DE 202018100148 U
(43) Veröffentlichungstag der Anmeldung: 18.11.2020
(73) Patentinhaber: Weightworks GmbH, 78467 Konstanz (DE)
(72) Erfinder: DIETZE, Frederic, 78476 Allensbach (DE)
(74) Vertreter: Grünecker Patent- und Rechtsanwälte PartG mbB
(86) Internationale Anmeldenummer: PCT/EP2019/050687
(87) Internationale Veröffentlichungsnummer: WO 2019/138072

(56) Entgegenhaltungen:
- EP-A2- 2 645 525
- DE-A1- 102011 013 182
- DE-A1- 102011 086 495
- DE-A1- 102012 203 585
- DE-A1- 102013 220 609
- DE-A1- 102014 203 919
- DE-A1- 102014 215 033
- DE-A1- 102015 002 080
- US-A1- 2017 144 562

## Beschreibung

Die vorliegende Erfindung betrifft eine Energiespeichervorrichtung, insbesondere für den Anlasser eines Verbrennungsmotors. Ebenso betrifft die Erfindung ein Kraftfahrzeug bzw. ein Überwachungssystem mit einer solchen Energiespeichervorrichtung sowie eine Verwendung einer solchen Energiespeichervorrichtung.

Es ist bekannt, den Betriebszustand von Starterbatterien auf Blei-Säure Basis zu überwachen, beispielsweise über eine Elektronikeinrichtung an einem Batteriepol, die in Echtzeit mit dem Steuergerät des jeweiligen Fahrzeugs kommuniziert. Hierbei können eine Vielzahl unterschiedlicher Werte übermittelt werden, insbesondere die Temperatur am Batteriepol, die Spannung zwischen den Batteriepolen, den aktuell entnommenen Strom oder die Kapazität. Ebenso ist es bekannt, den Ladezustand einer Starterbatterie über eine stand-alone Box zu überwachen, die den entnommenen Strom oder die aktuelle Spannung ermittelt. Derartige Überwachungssysteme für Batterien sind nur mit erheblichem Aufwand zu installieren, kostenintensiv und bieten eine nur eingeschränkte Funktionalität.

Im Gegensatz zu Starterbatterien auf Blei-Säure Basis können Starterbatterien mit Zellen auf Lithium-Basis beschädigt werden, sofern diese mittel- und/oder langfristig über oder unter einem bestimmten Spannungsniveau betrieben werden. Dies kann im Feldeinsatz beispielsweise durch ein Tiefentladen durch Verbraucher im Stand oder ein Überladen durch einen zu hohen Spannungsreglerwert der Lichtmaschine beziehungsweise durch einen Ausfall des Spannungsreglers der Lichtmaschine erfolgen. Bei Starterbatterien mit Zellen auf Lithium-Basis bestehen daher erhöhte Anforderungen an die Überwachung, um die Betriebssicherheit auch langfristig zu gewährleisten. Ebenso bestehen bei Starterbatterien auf LiFePO4 Basis erhöhte Anforderungen an die Überprüfung einzelner Zustände, insbesondere von Nicht-Betriebszuständen.

Vor diesem Hintergrund besteht die Aufgabe der vorliegenden Erfindung darin, eine Energiespeichervorrichtung anzugeben, die bei nur geringem Kosten- und Installationsaufwand eine verbesserte Überwachung beziehungsweise erweiterte Überwachungsfunktionalität und/oder Überprüfung ermöglicht. Ebenso besteht die Aufgabe darin, ein Überwachungssystem, ein Kraftfahrzeug, eine Verwendung einer Energiespeichervorrichtung sowie ein Verfahren zur Überwachung einer Energiespeichervorrichtung anzugeben. US 2017/144562 A1 offenbart eine Energiespeichervorrichtung mit Überwachungsfunktionalität aus dem Stand der Technik.

Diese Aufgabe wird gelöst durch eine Energiespeichervorrichtung nach Anspruch 1. Vorteilhafte Ausgestaltungen sind in den jeweils abhängigen Ansprüchen angegeben.

Eine erfindungsgemäße Energiespeichervorrichtung ist insbesondere für den Anlasser eines Verbrennungsmotors ausgebildet und umfasst: wenigstens ein Energiespeicherelement, eine Datenerzeugungseinheit zur Erfassung von Betriebskenngrößen der Energiespeichervorrichtung und zur Erzeugung entsprechender Daten, wobei die Betriebskenngrößen des Energiespeicherelements wenigstens den elektrischen Strom und/oder die elektrische Spannung des Energiespeicherelements umfassen, wenigstens eine Trennvorrichtung zur reversiblen Trennung einer elektrisch leitenden Verbindung zwischen dem Energiespeicherelement und einer Leistungsquelle und/oder einer elektrisch leitenden Verbindung zwischen dem Energiespeicherelement einem Leistungsempfänger, und eine Datenübertragungseinheit zur Datenübertragung zwischen der Datenerzeugungseinheit und einer Datenein-/ausgabevorrichtung sowie zwischen der Datenein-/ausgabevorrichtung und der Trennvorrichtung, wobei die Datenein-/ausgabevorrichtung ein Smartphone, ein Tablet oder ein Bordcomputer eines Fahrzeugs mit Bildschirm und Eingabeelementen ist, wobei die Trennvorrichtung sowohl in Abhängigkeit von Daten betätigbar ist, die von der Datenerzeugungseinheit unmittelbar an die Trennvorrichtung übermittelt werden, als auch in Abhängigkeit von Daten, die von der Datenübertragungseinheit an die Trennvorrichtung übermittelt werden, und die Datenein-/ ausgabevorrichtung (9) ausgebildet ist, die von der Datenerzeugungseinheit erfassten Betriebskenngrößen auszulesen, wobei die Energiespeichervorrichtung ein Gewicht im Bereich von 0,5 bis 5 kg, eine Kapazität im Bereich von 30 bis 1000 Wh und eine Nominalspannung im Bereich von 5 bis 24 V aufweist, wobei das Energiespeicherelement in einem Gehäuse aufgenommen ist, wobei ein Druckausgleich im Gehäuse über eine in einem Gehäusedeckel integrierte Membran realisiert wird, wobei die Membran so ausgestaltet ist, dass diese sich bei einer Temperatur über 100°C öffnet oder auflöst und so den Luftdurchsatz zusätzlich erhöht.

Mit einer derart ausgebildeten Energiespeichervorrichtung kann mit nur geringem Aufwand eine Überwachung und/oder Überprüfung des wenigstens einen Energiespeicherelements vorgenommen werden. Durch die Datenübertragungseinheit kann zudem die Überwachungs-und/oder Überprüfungsfunktionalität mit nur geringem Aufwand erweitert, insbesondere individuell auf den jeweiligen Anwendungsfall angepasst werden.

Beispielsweise erlaubt die erfindungsgemäße Energiespeichervorrichtung, die Temperatur des Energiespeicherelements im Betrieb stetig zu überwachen, so dass ein sogenannter "Thermal Runaway" beziehungsweise eine nachhaltige Beschädigung präventiv vermieden werden kann, insbesondere durch zusätzliche Sicherheitsfunktionalität, die durch die Datenübertragung zwischen der Datenübertragungseinheit und der Datenein-/ausgabevorrichtung mit nur geringem Aufwand bereitgestellt werden kann. So besteht die Möglichkeit, den Anwender möglichst in Echtzeit zu warnen oder eine Sicherheitsfunktion wie das Abstellen des Motors oder die Abklemmung beziehungsweise Trennung der Energiespeichervorrichtung von Verbrauchern oder Leistungsquellen zu initiieren, sofern sich die ermittelten Zustände außerhalb eines Soll-Bereichs befinden. Gegenüber einer rein akustischen Warnung des Anwenders, die überhört oder ignoriert werden kann, wird hierdurch die Betriebssicherheit signifikant erhöht.

Hierdurch wird der Funktionsumfang der Energiespeichervorrichtung in vorteilhafter Weise erweitert, wodurch insbesondere die Betriebssicherheit verbessert beziehungsweise etwaige Prüf- und/oder Diagnosevorgänge vereinfacht werden. Durch Auslesen der Betriebszustände und Erfassen bestimmter Betriebskenngrößen in Echtzeit während der Fahrt und Verwertung der Daten, beispielsweise in der Fahrzeugelektronik, kann in einem festgestellten Fehlerfall beziehungsweise bei Kurzschluss der Motor des Fahrzeugs abgestellt werden. Die Entwicklung von Feuer oder Schaden an der Starterbatterie mit Zellen auf Lithium-Basis kann somit verhindert werden. Schließlich können beispielsweise die Betriebszustände bzw. Betriebskenngrößen mit der Datenein-/ausgabevorrichtung, wie z.B. einem Smartphone, oder dem Bordcomputer des mit der Energiespeichervorrichtung bestückten Fahrzeugs ausgelesen und/oder überwacht werden. Beispielsweise kann ein Nutzer eine SMS erhalten, sofern der Akkumulator entladen oder Verbraucher im Stand angeschaltet sind. Die Gefahr vor Tiefentladen kann damit verringert und damit Verlängerung der Lebensdauer erzielt werden, da der Nutzer das Energiespeicherelement rechtzeitig nachladen beziehungsweise das jeweilige Fahrzeug starten kann.

Es kann von Vorteil sein, wenn die Energiespeichervorrichtung wenigstens eines der folgenden Merkmale aufweist:
- Die Energiespeichervorrichtung weist ein Gewicht im Bereich von 0,5 bis 5 kg, vorzugsweise im Bereich von 1 bis 3 kg, bevorzugt 1,1 kg, 1,9 kg oder 2,6 kg auf.
- Die Energiespeichervorrichtung erzeugt einen maximalen Entladungsstrom im Bereich von 200 bis 2000 A, vorzugsweise im Bereich von 400 bis 2000 A, bevorzugt 450 A, 750 A oder 1050 A.
- Die Energiespeichervorrichtung weist eine Kapazität im Bereich von 30 bis 1000 Wh, vorzugsweise im Bereich von 30 bis 250 Wh, bevorzugt 99 Wh, 165 Wh oder 231 Wh auf.
- Die Energiespeichervorrichtung weist eine Nominalspannung im Bereich von 5 bis 24V, vorzugsweise im Bereich von 9 bis 16 V, bevorzugt 13,2 V auf.
- Die Energiespeichervorrichtung weist eine Maximalspannung im Bereich von 5 bis 20 V, vorzugsweise im Bereich von 9 bis 16 V, bevorzugt 15,2 V auf.

Es kann aber auch sinnvoll sein, wenn das Energiespeicherelement wenigstens eines der folgenden Merkmale aufweist:
- Das Energiespeicherelement umfasst eine oder mehrere Energiespeicherzellen, vorzugsweise eine Batteriezelle, bevorzugt eine Sekundärbatterie- oder Akkuzelle beziehungsweise Becherzelle.
- Das Energiespeicherelement umfasst eine oder mehrere Lithium-Akkuzellen.
- Das Energiespeicherelement umfasst eine oder mehrere Lithium-Eisenphosphat-Akkuzellen.
- Das Energiespeicherelement ist als Starterakkumulator ausgebildet, vorzugsweise zur Speisung eines Anlassers eines Verbrennungsmotors.
- Das Energiespeicherelement ist als Starterakkumulator für Kraftfahrzeuge ausgebildet, insbesondere für den Einsatz in Motorsportfahrzeugen.
- Das Energiespeicherelement oder wenigstens eine Energiespeicherzelle ist zylindrisch, quaderförmig oder würfelförmig ausgebildet, wobei der Pluspol und der Minuspol vorzugsweise an verschiedenen Enden des Energiespeicherelements ausgebildet sind.
- Das Energiespeicherelement umfasst einen Arbeitstemperaturbereich von -30°C bis +60°C, vorzugsweise von 0°C bis +40°C, bevorzugt von +15°C bis +25°C.
- Das Energiespeicherelement umfasst eine Mehrzahl von Energiespeicherzellen, die vorzugsweise parallel und/oder in Reihe zueinander geschaltet sind.
- Das Energiespeicherelement umfasst eine Mehrzahl von Energiespeicherzellen die zu einem Zellenpaket in Reihe geschaltet sind.
- Das Energiespeicherelement umfasst eine Mehrzahl von Zellenpaketen mit in Reihe geschalteten Energiespeicherzellen, wobei die Zellenpakete zueinander parallel geschaltet sind.
- Das Energiespeicherelement umfasst genau 12 Energiespeicherzellen, wobei bevorzugt jeweils 4 Zellen zu einem Zellenpaket in Reihe geschaltet sind und weiter bevorzugt 3 Zellenpakete parallel geschaltet sind.
- Das Energiespeicherelement umfasst genau 20 Energiespeicherzellen, wobei bevorzugt jeweils 4 Zellen zu einem Zellenpaket in Reihe geschaltet sind und weiter bevorzugt 5 Zellenpakete parallel geschaltet sind.
- Das Energiespeicherelement umfasst genau 28 Energiespeicherzellen, wobei bevorzugt jeweils 4 Zellen zu einem Zellenpaket in Reihe geschaltet sind und weiter bevorzugt 7 Zellenpakete parallel geschaltet sind.
- Das Energiespeicherelement umfasst genau 20 Energiespeicherzellen, wobei bevorzugt jeweils 5 Zellen zu einem Zellenpaket in Reihe geschaltet sind und weiter bevorzugt 4 Zellenpakete parallel geschaltet sind.
- Das Energiespeicherelement umfasst genau 40 Energiespeicherzellen, wobei bevorzugt jeweils 5 Zellen zu einem Zellenpaket in Reihe geschaltet sind und weiter bevorzugt 8 Zellenpakete parallel geschaltet sind.

Akkuzellen auf Basis von Lithium zeichnen sich unter anderem aus durch die geringe Wärmeentwicklung beim Ladevorgang sowie eine hohe Leistungsdichte. Sie eignen sich in besonders vorteilhafter Weise für den Einsatz als Starterakkumulatoren. In Verbindung mit einer erfindungsgemäßen Überwachungseinrichtung kann eine insgesamt hohe Betriebssicherheit bei vorteilhaften Leistungen erreicht werden. Die paketförmige Anordnung einzelner Speicherzellen erleichtert die Montage und den Transport sowie die Verschaltung und Verbindung mit der jeweiligen Elektronik.

Es kann sich als hilfreich erweisen, wenn die Trennvorrichtung wenigstens eines der folgenden Merkmale aufweist:
- Die Trennvorrichtung umfasst wenigstens einen elektronischen Schalter zur reversiblen Trennung einer elektrisch leitenden Verbindung zwischen dem Energiespeicherelement und einer Leistungsquelle und/oder einer elektrisch leitenden Verbindung zwischen dem Energiespeicherelement und einem Leistungsempfänger, vorzugsweise wenigstens einen Hochleistungsschalter auf MOSFET Basis, bevorzugt wenigstens einen eigenen elektronischen Schalter für jede Energiespeicherzelle oder jede Gruppe/Reihe von Energiespeicherzellen des Energiespeicherelements, besonders bevorzugt jeweils einen elektronischen Schalter zur reversiblen Trennung der jeweiligen Energiespeicherzelle oder der jeweiligen Gruppe/Reihe von Energiespeicherzellen von einer Leistungsquelle und einen elektronischen Schalter zur reversiblen Trennung der jeweiligen Energiespeicherzelle oder der jeweiligen Gruppe/Reihe von Energiespeicherzellen von einem Leistungsempfänger.
- Die Trennvorrichtung umfasst eine Platine, auf der eine Steuerungselektronik implementiert ist.
- Die Trennvorrichtung umfasst wenigstens ein elektrisch leitendes Formteil, beispielsweise ein Stanz- und/oder Biegeteil z.B. aus Kupfer oder Messing, zum Leiten eines Stroms zu und/oder von dem Energiespeicherelement, vorzugsweise wenigstens ein elektrisch leitendes Formteil für jede Energiespeicherzelle oder jede Gruppe/Reihe von Energiespeicherzellen des Energiespeicherelements, besonders jeweils ein elektrisch leitendes Formteil zum Leiten eines Stroms von einem elektronischen Schalter gemäß Merkmal a zu der jeweiligen Energiespeicherzelle oder der jeweiligen Gruppe/Reihe von Energiespeicherzellen und jeweils ein elektrisch leitendes Formteil zum Leiten eines Stroms von der jeweiligen Energiespeicherzelle oder der jeweiligen Gruppe/Reihe von Energiespeicherzellen zu einem elektronischen Schalter gemäß Merkmal a.
- Die Trennvorrichtung umfasst eine Bodenplatte, vorzugsweise aus faserverstärktem Kunststoff, auf welcher die Platine gemäß Merkmal b und das wenigstens eine Formteil gemäß Merkmal c gemeinsam angeordnet sind.
- Wenigstens ein, mehrere oder jeder Schalter gemäß Merkmal a ist/sind in Abhängigkeit des ersten Datensignals und/oder des zweiten Datensignals und/oder des dritten Datensignals und/oder des vierten Datensignals der Datenerzeugungseinheit betätigbar, wobei vorzugsweise der jeweilige elektronische Schalter (3d, 3e) und das jeweilige Datensignal dieselbe Energiespeicherzelle oder dieselbe Gruppe/Reihe von Energiespeicherzellen des Energiespeicherelements betreffen.
- Wenigstens ein, mehrere oder jeder Schalter gemäß Merkmal a ist/sind in Abhängigkeit eines von der Datenübertragungseinheit an die Trennvorrichtung übermittelten Datensignals betätigbar.
- Wenigstens ein, mehrere oder jeder Schalter gemäß Merkmal a ist/sind in Abhängigkeit eines von der Datenanzeigeeinheit an die Trennvorrichtung übermittelten Datensignals betätigbar.
- Die Trennvorrichtung ist auf dem Deckel eines Gehäuses der Energiespeichervorrichtung angeordnet oder in einer entsprechenden Aufnahme im Deckel des Gehäuses der Energiespeichervorrichtung angeordnet oder von innen im Deckel des Gehäuses der Energiespeichervorrichtung eingeklebt bzw. verschraubt.
- Die Trennvorrichtung ist eingerichtet, um beim Empfangen eines Datensignals von der Datenerzeugungseinheit, das eine zu geringe Temperatur des Energiespeicherelements oder einer Energiespeicherzelle oder einer Gruppe/Reihe von Energiespeicherzellen des Energiespeicherelements anzeigt, eine elektrisch leitende Verbindung zwischen dem Energiespeicherelement und einem Leistungsempfänger beispielsweise in Gestalt eines Anlassers für einen Verbrennungsmotor zu unterbrechen und eine elektrisch leitende Verbindung zwischen dem Energiespeicherelement oder der Energiespeicherzelle oder der Gruppe/Reihe von Energiespeicherzellen und einem anderen Leistungsempfänger herzustellen.
- Die Trennvorrichtung ist eingerichtet, um beim Empfangen eines Datensignals von der Datenerzeugungseinheit, das eine richtige Temperatur des Energiespeicherelements oder einer Energiespeicherzelle oder einer Gruppe/Reihe von Energiespeicherzellen des Energiespeicherelements anzeigt, eine elektrisch leitende Verbindung zwischen dem Energiespeicherelement und einem Leistungsempfänger beispielsweise in Gestalt eines Anlassers für einen Verbrennungsmotor herzustellen.
- Die Trennvorrichtung ist eingerichtet, um eine elektrisch leitende Verbindung zwischen dem Energiespeicherelement und einem Leistungsempfänger beispielsweise in Gestalt eines Anlassers für einen Verbrennungsmotor beim Empfangen eines ersten Datensignals von der Datenübertragungseinheit zu unterbrechen, und beim Empfangen eines zweiten Datensignals von der Datenübertragungseinheit herzustellen.
- Die Trennvorrichtung ist eingerichtet, um die elektrisch leitende Verbindung nach einer Trennung der elektrisch leitenden Verbindung beim Empfangen eines Datensignals von der Datenübertragungseinheit oder beim Empfangen eines Datensignals, das das Anschließen eines Ladegeräts oder das Anlegen eine Initialspannung zwischen den Polen anzeigt, wiederherzustellen.

Es kann nützlich sein, wenn die Datenerzeugungseinheit wenigstens eines der folgenden Merkmale aufweist:
- Die Datenerzeugungseinheit ist eingerichtet, wenigstens eine der folgenden Betriebskenngrößen der Energiespeichervorrichtung zu erfassen und entsprechende Daten zu erzeugen:
   ∘ Die elektrische Spannung des Energiespeicherelements, vorzugsweise die elektrische Spannung einer einzelnen Energiespeicherzelle oder einer Gruppe/Reihe von Energiespeicherzellen des Energiespeicherelements, bevorzugt die elektrische Spannung jeder Energiespeicherzelle oder jeder Gruppe/Reihe von Energiespeicherzellen des Energiespeicherelements.
   ∘ Den elektrischen Strom des Energiespeicherelements, vorzugsweise den elektrischen Strom einer einzelnen Energiespeicherzelle oder einer Gruppe/Reihe von Energiespeicherzellen des Energiespeicherelements, bevorzugt den elektrischen Strom jeder Energiespeicherzelle oder jeder Gruppe/Reihe von Energiespeicherzellen des Energiespeicherelements.
   ∘ Die Temperatur des Energiespeicherelements, vorzugsweise die Temperatur einer einzelnen Energiespeicherzelle oder einer Gruppe/Reihe von Energiespeicherzellen des Energiespeicherelements, bevorzugt die Temperatur jeder Energiespeicherzelle oder jeder Gruppe/Reihe von Energiespeicherzellen des Energiespeicherelements.
   ∘ Den Druck innerhalb oder in der Umgebung der Energiespeichervorrichtung, insbesondere innerhalb eines Gehäuses der Energiespeichervorrichtung.
   ∘ Den Feuchtigkeitsgehalt innerhalb oder in der Umgebung der Energiespeichervorrichtung, insbesondere innerhalb eines Gehäuses der Energiespeichervorrichtung.
   ∘ Die Gaszusammensetzung innerhalb oder in der Umgebung der Energiespeichervorrichtung, insbesondere innerhalb eines Gehäuses der Energiespeichervorrichtung.
   ∘ Eine Beschleunigung der Energiespeichervorrichtung (G-Sensor).
   ∘ Einen Standort der Energiespeichervorrichtung (GPS-Sensor).
- Die Datenerzeugungseinheit ist eingerichtet, um ein erstes Datensignal zu erzeugen, wenn wenigstens eine der Betriebskenngröße innerhalb eines entsprechenden Betriebskenngrößenbereichs liegt, wobei der entsprechende Betriebskenngrößenbereich vorzugsweise verstellbar ist, bevorzugt mittels der Datenein-/ausgabevorrichtung, so dass u. A. bei starker Verzögerung (Crash/Unfall) des Fahrzeugs ein Signal zu der Trennvorrichtung gesendet werden kann, um die Stromversorgung unmittelbar zu unterbrechen.
- Die Datenerzeugungseinheit ist eingerichtet, um ein zweites Datensignal zu erzeugen, wenn wenigstens eine der Betriebskenngrößen außerhalb eines entsprechenden Betriebskenngrößenbereichs liegt, wobei der entsprechende Betriebskenngrö-ßenbereich vorzugsweise verstellbar ist, bevorzugt mittels der Datenein-/ausgabevorrichtung.
- Die Datenerzeugungseinheit ist eingerichtet, um ein drittes Datensignal zu erzeugen, wenn wenigstens eine der Betriebskenngrößen unterhalb eines entsprechenden Betriebskenngrößenwerts liegt, wobei der entsprechende Betriebskenngrößenwert vorzugsweise verstellbar ist, bevorzugt mittels der Datenein-/ausgabevorrichtung.
- Die Datenerzeugungseinheit ist eingerichtet, um ein viertes Datensignal zu erzeugen, wenn wenigstens eine der Betriebskenngrößen oberhalb eines entsprechenden Betriebskenngrößenwerts liegt, wobei der entsprechende Betriebskenngrößenwert vorzugsweise verstellbar ist, bevorzugt mittels der Datenein-/ausgabevorrichtung.
- Die Datenerzeugungseinheit ist zum Überwachen des Betriebszustands des Energiespeicherelements eingerichtet, insbesondere zur Echtzeitüberwachung.
- Die Datenerzeugungseinheit ist zur Prüfung einzelner Zustände des Energiespeicherelements eingerichtet, bevorzugt zur Überprüfung eines Nicht-Betriebszustandes, des Auslieferungszustandes, eines Zustandes zu Diagnosezwecken und/oder eines Zustandes in Trennung der Energiespeichervorrichtung von einer Leistungsquelle und/oder einem Leistungsempfänger.
- Die Datenerzeugungseinheit ist zur Erfassung von Fehlzuständen des Energiespeicherelements eingerichtet, bevorzugt zur Erfassung kritischer Spannungs-, Strom-, Temperatur-, Druck-, Feuchtigkeit- und/oder Gaswerten eingerichtet, weiter bevorzugt zur Erfassung von jeweiligen Höchst- und/oder Niedrigstwerten.
- Die Datenerzeugungseinheit ist zur Speicherung erfasster Daten eingerichtet, insbesondere erfasster elektrischer Spannungen, Strömen, Temperaturen, Drücken, Feuchtigkeitswerten, Gaswerten, Fehlzuständen, Höchst- und/oder Niedrigstwerten.
- Die Datenerzeugungseinheit ist zur Übermittlung erfasster und/oder gespeicherter Daten mittels der Kommunikationseinrichtung eingerichtet.
- Die Datenerzeugungseinheit weist einen Sensor zur Erfassung der elektrischen Spannung des Energiespeicherelements und/oder einen Vorrichtung zur Erfassung elektrischer Ströme, bevorzugt einen Stromsensor oder Shunt, und/oder einen Temperatursensor zur Erfassung der Temperatur des Energiespeicherelements und/oder einen Drucksensor und/oder einen Feuchtigkeitssensor und/oder einen Gassensor, bevorzugt zur Ermittlung der Veränderung der Zellchemie des Energiespeicherelements und/oder einen Standortsensor, bevorzugt einen GPS Sensor.
- Die Datenerzeugungseinheit weist eine Speichereinheit zur Speicherung erfasster Daten auf.
- Die Datenerzeugungseinheit weist eine Datenverarbeitungsvorrichtung zur Verarbeitung erfasster und/oder gespeicherter Daten auf.
- Die Datenerzeugungseinheit ist zur Übermittlung erfasster und/oder gespeicherter Daten an eine Fahrzeugsteuerung eingerichtet.
- Die Datenerzeugungseinheit ist zur Übermittlung erfasster und/oder gespeicherter Daten mittels der Kommunikationseinrichtung an ein stationäres oder mobiles Endgerät, insbesondere einem Smartphone, eingerichtet, wobei auf den Daten basierende Informationen in einem auf dem Endgerät installierten Anwenderprogramm darstellbar sind, vorzugsweise graphisch und/oder in Textform.
- Die Datenerzeugungseinheit ist zur Übermittlung erfasster und/oder gespeicherter Daten an ein stationäres oder mobiles Monitoringsystem, bevorzugt mit einem Display, eingerichtet.
- Die über die Datenerzeugungseinheit kommunizierten Daten können auf einem Kundenserver abgelegt werden, was einen erweiterten Kundenservice ermöglicht.
- Die über die die Datenerzeugungseinheit kommunizierten Daten können als Datenbasis für eine Remote-Wartung dienen bzw. zur präventiven Fehlererkennung genutzt werden ("Internet of Things").

Es kann sich als praktisch erweisen, wenn die Datenübertragungseinheit wenigstens eines der folgenden Merkmale aufweist:
- Die Datenübertragungseinheit ist zur kontaktlosen Signal- und/oder Energieübertragung eingerichtet.
- Die Datenübertragungseinheit ist zur kontaktlosen Kommunikation, bevorzugt zur kontaktlosen Datenübertragung ausgebildet.
- Die Datenübertragungseinheit ist zum Senden und/oder Empfangen von Daten ausgebildet.
- Die Datenübertragungseinheit ist zum Speisen und/oder Empfangen elektrischer Energie ausgebildet.
- Die Datenübertragungseinheit ist zur Datenübertragung mittels Funktechnik und/oder Lichtwellen eingerichtet.
- Die Datenübertragungseinheit ist zur Datenübertragung mittels RFID-Technik, Nahfeldkommunikation (NFC), Bluetooth und/oder WLAN eingerichtet.
- Die Datenübertragungseinheit ist als Antenne zur Nahfeldkommunikation (NFC) ausgebildet, insbesondere als NFC-Tag.
- Die Datenübertragungseinheit ist zur Signal-, Daten und/oder Energieübertragung mittels Induktion und/oder magnetischer Kopplung ausgebildet.
- Die Datenübertragungseinheit ist als Reedschalter ausgebildet.
- Die Datenübertragungseinheit ist für den gesicherten Datenaustausch, insbesondere für den kryptografisch gesicherten Datenaustausch ausgebildet.
- Die Datenübertragungseinheit ist zur aktiv-passiv und/oder zur aktiv-aktiv (peer-topeer) Kommunikation eingerichtet.
- Die Datenübertragungseinheit ist zur Kommunikation via CAN oder LIN-bus eingerichtet.

Beispielsweise ist es möglich, über ein Smartphone mit Bluetooth-Schnittstelle oder einen Card-Reader mit Bluetooth, sämtliche Betriebszustände des verbauten Energiespeicherelements auszulesen und so Rückschlüsse über den Zustand beziehungsweise den bisherigen Einsatz zu erhalten und/oder mittels eines Eingabegeräts mit Bluetooth-Schnittstelle jeweils gewünschte Schaltzustände der Überwachungseinrichtung einzugeben, beispielsweise zur Initiierung einer Zurücksetzung (Reset). Das Auslesen kann beispielsweise im Gewährleistungs- oder Schadensfall von Vorteil sein, da somit ohne großen Aufwand Fehlanwendungen rechtzeitig erkannt beziehungsweise eindeutig nachgewiesen werden können. Zudem kann der Zustand des Energiespeicherelements ermittelt werden, ohne die Energiespeichervorrichtung zu öffnen oder einen handhabungsintensiven Anschluss eines entsprechenden Diagnosegeräts vorzunehmen. Auf kostenintensive Steckverbindungen kann verzichtet werden.

Es kann aber auch von Nutzen sein, wenn das Energiespeicherelement in einem Gehäuse aufgenommen ist, wobei bevorzugt auch die Datenerzeugungseinheit und/oder die Datenübertragungseinheit innerhalb des Gehäuses oder an diesem angeordnet ist/sind, wobei vorzugsweise ein Druckausleich im Gehäuse über eine im Gehäusedeckel integrierte Membran realisiert wird, wobei die Membran bevorzugt ist so ausgestaltet, dass diese sich bei einer Temperatur über 100°C öffnet oder auflöst und so den Luftdurchsatz zusätzlich erhöht. Hierdurch kann ein kompakter Aufbau gewährleistet werden, wodurch Transport und Montage beziehungsweise Einbau erleichtert werden und die Betriebssicherheit erhöht wird.

Es kann sinnvoll sein, wenn die Datenerzeugungseinheit zwischen dem Energiespeicherelement und einer Gehäusewand angeordnet ist, vorzugsweise zwischen dem Energiespeicherelement und dem einem Deckel des Gehäuses und/oder wobei das Gehäuse einen Deckel aufweist, an dessen Innenseite die Datenübertragungseinheit angeordnet ist. Der Gesamtaufbau kann hierdurch kompakt ausfallen. Gleichzeitig wird hierdurch eine sichere Befestigung der Datenerzeugungseinheit und/oder der Datenübertragungseinheit ermöglicht.

Es kann sich als hilfreich erweisen, wenn die Trennvorrichtung separat von dem Energiespeicherelement ausgebildet und/oder beabstandet von dem Energiespeicherelement angeordnet ist und/oder wobei die Trennvorrichtung in der Energiespeichervorrichtung integriert ist, bevorzugt innerhalb eines Gehäuses der Energiespeichervorrichtung angeordnet ist. Durch eine derartige Energiespeichervorrichtung lässt sich beispielsweise bei zu hohen oder zu niedrigen Spannungen eine Trennung der Energiespeichervorrichtung initiieren, sodass Schäden vermieden werden können. Eine Trennung kann dabei beispielsweise automatisiert oder durch Benutzereingabe veranlasst werden. Die Betriebssicherheit wird hierdurch weiter verbessert. Eine derartige Ausgestaltung kann das Diebstahlrisiko eines Fahrzeugs mit nur geringem Aufwand verringern.

Insbesondere kann hierdurch die Energiespeichervorrichtung beziehungsweise das darin enthaltene Energiespeicherelement und damit das Fahrzeug aus der Distanz deaktiviert werden, ähnlich einer Wegfahrsperre. Sofern die Energiespeichervorrichtung über eine Leistungselektronik von der KFZ-Lichtmaschine gespeist wird, kann die als Leistungselektronik ausgebildete Trennvorrichtung diese im Bedarfsfall trennen. Die Kommunikation beziehungsweise das Signal wird erfindungsgemäß über die Datenübertragungseinheit übertragen. Eine derartige Leistungselektronik kann dazu eingerichtet sein, hohe Ströme über eine längere Zeitspanne, z.B. 200A über >10sec, oder Peak-Ströme über eine sehr kurze Zeitspannen, z.B. 1000A über <1sec, zu übertragen.

Nach einer weiteren Ausgestaltung ist die Trennvorrichtung separat von dem Energiespeicherelement ausgebildet und/oder beabstandet von dem Energiespeicherelement angeordnet. Der Gestaltungsspielraum für die Montage der unterschiedlichen Komponenten in oder an einem Fahrzeug wird somit erhöht. Ebenso kann die Trennvorrichtung in der Energiespeichervorrichtung integriert, bevorzugt innerhalb eines Gehäuses der Energiespeichervorrichtung angeordnet sein, wodurch ein insgesamt kompakter Aufbau sichergestellt wird.

Eine Trennvorrichtung, insbesondere zur Trennung einer Energiespeichervorrichtung von einer Leistungsquelle und/oder einem Leistungsempfänger, kann eine Leistungselektronik aufweisen und zur Interaktion mit einer Datenerzeugungseinheit einer Energiespeichervorrichtung und/oder einem stationären oder mobilen Endgerät eingerichtet sein, um in Abhängigkeit empfangener und/oder gesendeter Daten eine Trennung der Energiespeichervorrichtung durchzuführen.

Ein weiterer Aspekt der Erfindung betrifft ein Kraftfahrzeug, insbesondere für den Motorsport, mit einem Verbrennungsmotor, einem Anlasser sowie einer Energiespeichervorrichtung nach einer der vorangehenden Ausführungen. Ein derartiges Fahrzeug weist eine erhöhte Betriebssicherheit und/oder einen verbesserten Diebstahlschutz auf.

Ein weiterer Aspekt der vorliegenden Erfindung betrifft ein Überwachungssystem mit wenigstens einer Energiespeichervorrichtung nach einer der vorangehenden Ausführungen und einer Datenein-/ausgabevorrichtung zum Datenaustausch mit der Datenerzeugungseinheit der Energiespeichervorrichtung. Durch ein derartiges Überwachungssystem können etwaige Sicherheitsfunktionalitäten in vorteilhafter Weise durch die Datenein-/ausgabevorrichtung bereitgestellt werden. Beispielsweise kann der jeweilige Betriebszustand aktiv von einem Anwender und/oder von geschultem Überwachungspersonal mittels der Datenein-/ausgabevorrichtung überwacht werden. Bei Feststellung etwaiger Fehlzustände können aktiv Sicherheitsmaßnahmen eingeleitet werden. Beispielsweise bekommt der Nutzer eine Meldung auf sein Smartphone, sobald das Fahrzeug bewegt wird oder die Alarmanlage anschlägt, beziehungsweise sobald Strom entnommen wird, und die Energiespeichervorrichtung kann dann aus der Ferne oder autark durch das System bei Startvorgang ohne vorherige Freischaltung deaktiviert werden.

Ein weiterer Aspekt der vorliegenden Erfindung betrifft die Verwendung einer Energiespeichervorrichtung nach einem einer der vorangehenden Ausführungen als Energiespeichervorrichtung für Kraftfahrzeuge, vorzugsweise im Motorsport. Eine derartige Energiespeichervorrichtung eignet sich in besonders vorteilhafter Weise für den Einsatz im Motorsport, insbesondere aufgrund der hohen Leistungsdichte und der verbesserten Betriebssicherheit.

Ein weiterer Aspekt der vorliegenden Erfindung betrifft ein Verfahren zur Überwachung einer Energiespeichervorrichtung, bei der mittels einer Datenerzeugungseinheit wenigstens eine Betriebskenngröße der Energiespeichervorrichtung erfasst und entsprechende Daten erzeugt werden, die mittels einer Datenübertragungseinheit an eine Datenein-/ausgabevorrichtung übertragen werden. Durch ein derartiges Verfahren kann in vorteilhafter Weise mit nur geringem Aufwand eine Überwachung und/oder Überprüfung der Energiespeichervorrichtung vorgenommen werden. Durch die Datenübertragung zwischen der Datenerzeugungseinheit und externer Peripherie kann zudem die Überwachungs- und/oder Überprüfungsfunktionalität mit nur geringem Aufwand erweitert und insbesondere individuell auf den jeweiligen Anwendungsfall angepasst werden.

Die Erfindung ist nicht auf die ausdrücklich beschriebenen Ausführungsformen beschränkt. Weitere vorteilhafte Ausführungsbeispiele ergeben sich durch Kombinationen der Merkmale, die in den Ansprüchen, der Beschreibung und den Zeichnungen offenbart sind. Nachfolgend wird die Erfindung anhand einer Ausführungsbeispiele zeigenden Zeichnung näher erläutert.

### Begriffe und Definitionen

Die Datenerfassungseinheit im Sinne der Erfindung umfasst beispielsweise wenigstens einen Sensor zur Erfassung wenigstens einer Betriebskenngröße der Energiespeichervorrichtung und zur Erzeugung von entsprechenden Daten, vorzugsweise in digitaler Form.

Die Datenübertragungseinheit im Sinne der Erfindung umfasst beispielsweise eine Datenschnittstelle. Die Datenübertragung kann per Draht oder drahtlos (z.B. WLAN oder Bluetooth) erfolgen.

Die Leistungsquelle im Sinne der Erfindung umfasst beispielsweise die Lichtmaschine eines Fahrzeugs, insbesondere die Lichtmaschine des mit der Energiespeichervorrichtung bestückten Fahrzeugs. Die Leistungsquelle gehört nicht zur Energiespeichervorrichtung.

Der Leistungsempfänger im Sinne der Erfindung ist beispielsweise der Anlasser eines Verbrennungsmotors eines Fahrzeugs, insbesondere der Anlasser des Verbrennungsmotors des mit der Energiespeichervorrichtung bestückten Fahrzeugs. Weitere Leitungsempfänger sind gegebenenfalls Verbraucher wie Bordelektronik oder integrierte Widerstände zur gezielten Energieentnahme mit dem Ziel der Erhöhung der Temperatur der Energiespeichervorrichtung oder einzelner Energiespeicherzellen. Der Leistungsempfänger gehört nicht zur Energiespeichervorrichtung.

Die Datenein-/ausgabevorrichtung im Sinne der Erfindung ist beispielsweise ein Smartphone, ein Tablet oder ein Bordcomputer eines Fahrzeugs mit Bildschirm und Eingabeelementen, insbesondere der Bordcomputer des mit der Energiespeichervorrichtung bestückten Fahrzeugs.

Die Trennvorrichtung im Sinne der Erfindung ist beispielsweise eine plattenförmige Anordnung mit Platine, MOSFETs und mehreren Formteilen, wie in den Figuren dargestellt.

### Kurze Beschreibung der Figuren:

Es zeigen:
- Fig. 1: eine schematische Querschnittsansicht einer Energiespeichervorrichtung nach einem Ausführungsbeispiel der vorliegenden Erfindung.
- Fig. 2: eine schematische Draufsicht einer Energiespeichervorrichtung nach einem Ausführungsbeispiel der vorliegenden Erfindung.
- Fig. 3: eine schematische Darstellung einer Energiespeichervorrichtung mit daran angeschlossener Lichtmaschine eines Kraftfahrzeugs nach einem Ausführungsbeispiel der vorliegenden Erfindung.
- Fig. 4: in Ansicht (a) eine Draufsicht auf eine Trennvorrichtung der erfindungsgemäßen Energiespeichervorrichtung und in Ansicht (b) ein vergrößertes Detail C der Ansicht (a).
- Fig. 5: in Ansicht (a) eine Schnittansicht der Trennvorrichtung gemäß Fig. 4 entlang der Linie A-A aus Fig. 4a und in Ansicht (b) ein vergrößertes Detail B der Ansicht (a).
- Fig. 6: ein Schemadiagramm der Energiespeichervorrichtung nach einem Ausführungsbeispiel der vorliegenden Erfindung.

### Detaillierte Beschreibung der bevorzugten Ausführungsbeispiele:

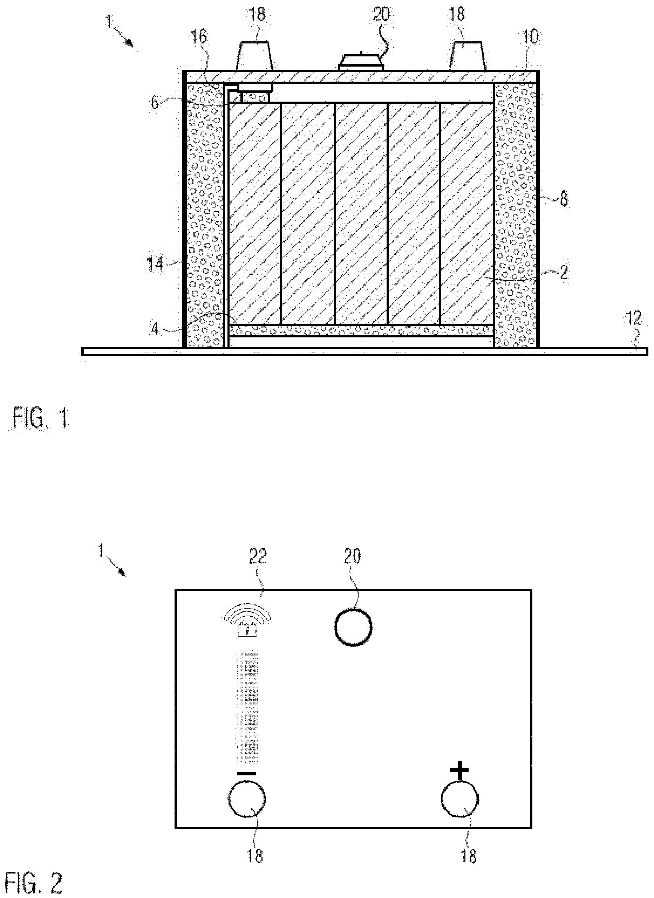

Figur 1 zeigt eine schematische Querschnittsansicht einer Energiespeichervorrichtung 1 nach einem Ausführungsbeispiel der vorliegenden Erfindung. Die Energiespeichervorrichtung 1 ist insbesondere zur Speisung eines Anlassers eines Verbrennungsmotors ausgebildet. Die Energiespeichervorrichtung 1 weist wenigstens ein Energiespeicherelement 2, eine Datenerzeugungseinheit 4 zur Erfassung von Betriebskenngrößen der Energiespeichervorrichtung 1, insbesondere des Energiespeicherelements der Energiespeichervorrichtung 1 sowie zur Erzeugung entsprechender Daten vorzugsweise in digitaler Form und eine Datenübertragungseinheit 6 zur Datenübertragung zwischen der Datenerzeugungseinheit 4 und einer externen Datenein-/ausgabevorrichtung 9 in Gestalt eines Smartphones oder eines externen Signalgebers (Schalter/Taster) oder über das Fahrzeugkommunikationssystem via CAN oder LIN-Bus, über das beispielsweise eine hinreichend verlässliche, redundante Kommunikation bzw. Abschaltung gewährleistet werden kann, auf.

Weiterhin weist die Energiespeichervorrichtung 1 ein Gehäuse 8 auf, das bevorzugt aus CFK ausgebildet ist. Das Gehäuse kann ferner mit einem Deckel 10 ausgestattet sein. Das wenigstens eine Energiespeicherelement 2, die Datenerzeugungseinheit 4 sowie die Datenübertragungseinheit 6 sind bevorzugt innerhalb des Gehäuses 8 angeordnet, das durch den Deckel 10 verschlossen ist. Das Gehäuse 8 kann ferner eine Bodenplatte 12 aufweisen, die ebenfalls aus CFK ausgebildet sein kann. Die Bodenplatte 12 kann über die Gehäuseseitenwände hervorstehen. Der Gehäuseinnenraum ist mit einem Schaum 14 ausgestattet, in dem das Energiespeicherelement 2 aufgenommen ist.

Bevorzugt sind eine Mehrzahl von Energiespeicherelementen 2 vorgesehen, die weiter bevorzugt als Lithium-Akkuzellen ausgebildet sind. Die Datenerzeugungseinheit 4 ist beispielsweise als Elektronik in Form einer Platine ausgebildet, die zwischen den Energiespeicherelementen 2 sowie einem Gehäuseboden angeordnet ist, bevorzugt zwischen dem Gehäuseboden und einer Schaumschicht unterhalb der Energiespeicherelemente 2. Die Datenübertragungseinheit 6 ist bevorzugt als NFC-Antenne ausgebildet und an der Innenseite des Deckels 10 angeordnet. Die Datenerzeugungseinheit 4 und die Datenübertragungseinheit 6 können durch eine Kabelanordnung 16 miteinander verbunden sein.

Wie den Figuren 1 und 2 entnommen werden kann, weist die Energiespeichervorrichtung 1 Pole 18 auf, über die eine elektrische Verbindung der Energiespeicherelemente 2 mit einer Leistungsquelle und/oder mit einem Leistungsempfänger hergestellt werden kann. Die Pole 18 sind an einer Außenseite des Deckels 10 angeordnet. Der Deckel 10 weist ferner ein Druckausgleichsventil 20 auf, durch das ein möglicherweise entstehender Überdruck im Gehäuseinnenraum ausgeglichen werden kann. Zudem kann ein durch Ausgasen der Akkuzellen bei Überlastung entstehender Überdruck effektiv und kontrolliert abgelassen werden, um einem explosionsartigen Bersten des Gehäuses effektiv vorzubeugen. Der Druckausleich wird über eine Membran realisiert, die im Gehäusedeckel integriert ist. Die Membran ist so ausgestaltet, dass diese sich beim erhöhter Temperatur >100°C auflöst und so den Luftdurchsatz zusätzlich erhöht.

An der Außenseite des Deckels 10 kann ferner ein Symbol 22 angeordnet sein, welches auf die Datenübertragungseinheit 6 verweist. Insbesondere kann das Symbol 22 die Technologie der jeweiligen Datenübertragungseinheit 6 verdeutlichen, beispielsweise die NFC-Technologie symbolisieren.

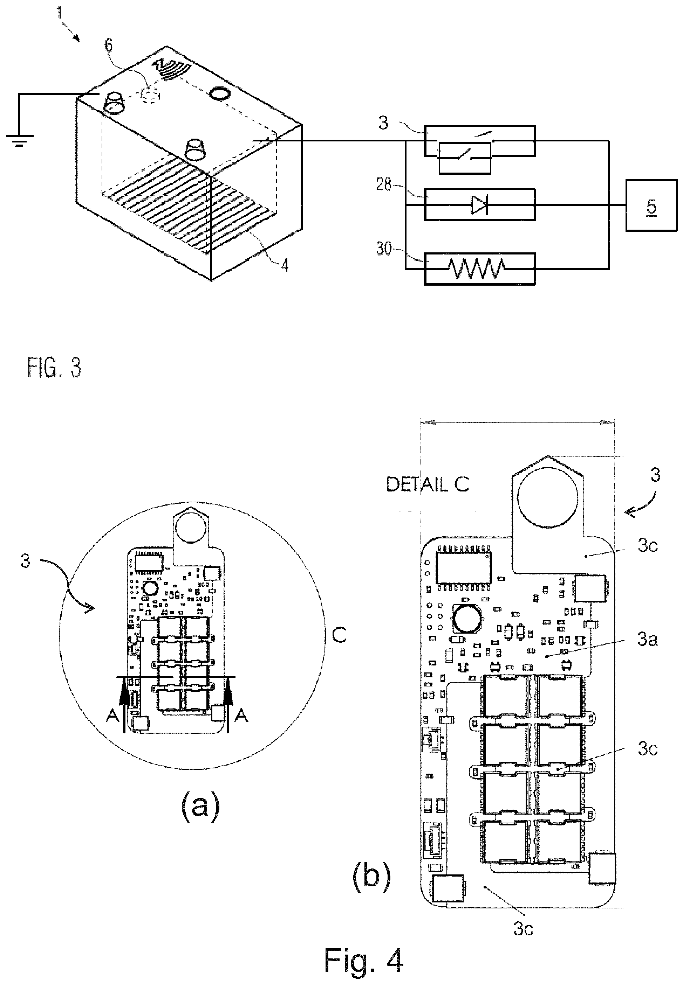

Figur 3 zeigt eine Energiespeichervorrichtung 1 mit einer daran angeschlossenen KFZ-Lichtmaschine als Leistungsquelle 5. Zwischen der Energiespeichervorrichtung 1 und der Lichtmaschine 24 ist eine Trennvorrichtung 3 vorgesehen, die zur Trennung der Energiespeichervorrichtung 1 von der Leistungsquelle 5, wie z.B. der Lichtmaschine, und/oder einem Leistungsempfänger 7, wie z.B. einem hier nicht dargestellten Anlasser, eingerichtet ist. Dabei ist die Trennvorrichtung 3 zur Interaktion mit der Datenerzeugungseinheit 4 und/oder über die Datenübertragungseinheit 6 mit der Datenein-/ausgabevorrichtung 9 eingerichtet. In Abhängigkeit empfangener und/oder gesendeter Daten kann die Trennvorrichtung 3 eine Trennung des Energiespeicherelements 2 von der Leistungsquelle 5 und/oder dem Leistungsempfänger 7 durchführen. Die Trennvorrichtung 3 kann als externe Peripherie oder innerhalb des Gehäuses 8 der Energiespeichervorrichtung 1 angeordnet sein.

Ferner kann zwischen der Energiespeichervorrichtung 1 und der Lichtmaschine 5 eine Vorrichtung 28 zur Erzeugung eines Spannungsabfalls angeordnet sein, die bevorzugt als Diode ausgebildet ist. Eine derartige Vorrichtung 28 kann die Energiespeicherelemente 2 vor übermäßiger Speisung durch die Lichtmaschine 5 schützen, insbesondere, wenn durch die Lichtmaschine 5 eine dauerhaft zu hohe Speisung erfolgt.

Schließlich kann zwischen der Energiespeichervorrichtung 1 und der Lichtmaschine 5 eine Vorrichtung 30 zur Erfassung elektrischer Ströme angeordnet sein, die Rückschlüsse über die Ladekapazität ermöglicht. Die Vorrichtung 28 und/oder die Vorrichtung 30 können beide als Teil der Datenerzeugungseinheit 4 ausgebildet und innerhalb des Gehäuses 8 angeordnet sein. Ebenso können die Vorrichtung 28 und/oder die Vorrichtung 30 als externe Peripherie ausgebildet sein.

Eine voranstehend beschriebene Energiespeichervorrichtung 1 ist in besonders vorteilhafter Weise als Starterakkumulator für den Motorsport einzusetzen. Mit einer derart ausgebildeten Energiespeichervorrichtung 1 kann mit nur geringem Aufwand eine Überwachung und/oder Überprüfung des wenigstens einen Energiespeicherelements 2 vorgenommen werden. Durch die Datenübertragung zwischen der Datenerzeugungseinheit 4 und der Datenein-/ausgabevorrichtung 9 über die Datenübertragungseinheit 6 kann zudem die Überwachungs-und/oder Überprüfungsfunktionalität mit nur geringem Aufwand erweitert, insbesondere individuell auf den jeweiligen Anwendungsfall angepasst werden. Da die Lichtmaschine im KFZ-Bereich unterschiedlich angesteuert wird (durchgeschleift/nicht durchgeschleift), muss bei spezifischen Anwendungen ein separat abschaltbarer Pluspol für relevante Fahrzeugperipherie (z. B. Benzinpumpe oder ECU) vorgesehen werden, der sich innerhalb oder außerhalb des Gehäuses befinden kann und drahtlos oder über ein kabelgebundenes Signal geschaltet werden kann.

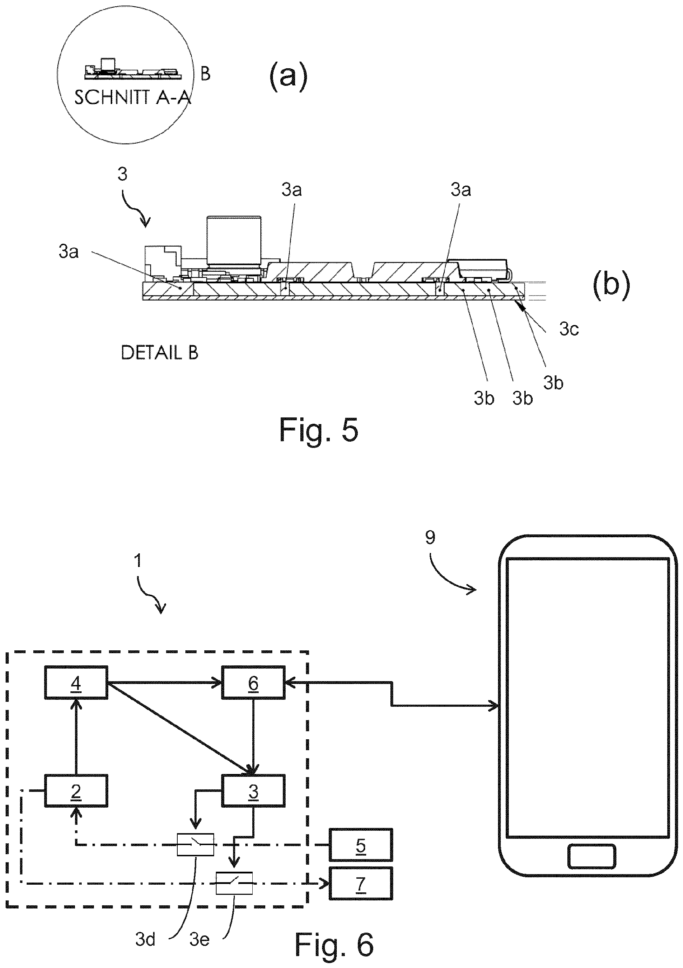

Figur 6 zeigt schematisch den Aufbau und die Funktionsweise der Energiespeichervorrichtung 1. Die Komponenten der Energiespeichervorrichtung 1 sind innerhalb eines gestrichelten Rechtecks durch rechteckige Symbole mit entsprechenden Bezugszeichen dargestellt. Die Datenströme zwischen den Komponenten der Energiespeichervorrichtung 1 und der Datenein-/ausgabevorrichtung 9 sind durch Pfeile mit durchgezogenen Linien symbolisiert. Pfeile mit Strichpunktinien zeigen die elektrisch leitenden Verbindungen zwischen dem Energiespeicherelement 2 und der Leistungsquelle 5 wie z.B. der Lichtmaschine eines Fahrzeugs bzw. dem Leistungsempfänger 7 wie dem Anlasser des Fahrzeugs an. In die Verbindung zwischen dem Energiespeicherelement 2 und der Leistungsquelle 5 ist ein als Hochleistungsschalter auf MOSFET-Basis ausgebildeter Schalter 3d integriert, der als Teil der Trennvorrichtung 3 von der Steuerungselektronik betätigbar ist, um die Verbindung zwischen dem Energiespeicherelement 2 und der Leistungsquelle 5 wahlweise zu trennen oder herzustellen. Ebenso befindet sich zwischen dem Energiespeicherelement 2 und dem Leistungsempfänger 7 ein als Hochleistungsschalter auf MOSFET-Basis ausgebildeter Schalter 3e, der als Teil der Trennvorrichtung 3 von der Steuerungselektronik betätigbar ist, um die Verbindung zwischen dem Energiespeicherelement 2 und dem Leistungsempfänger 7 wahlweise zu trennen oder herzustellen. Vorzugsweise befinden sich entsprechende Schalter 3d, 3e zwischen jeder Energiespeicherzelle oder Gruppe/Reihe von Energiespeicherzellen und der Leistungsquelle 5 bzw. dem Leistungsempfänger 7.

Mithin umfasst die erfindungsgemäße Energiespeichervorrichtung 1 neben einer intelligenten Steuerelektronik mit integrierter Sensorik zusätzlich einen innovativen Lastschalter in Gestalt der Trennvorrichtung 3, die es über die Schalter 3d, 3e ermöglicht, die verwendeten Akkuzellen aktiv in Lade- und Entladerichtung gesondert zu trennen und zusätzlich auch den effektiven Strom zu messen.

Diese als Batteriemanagementsystem (BMS) bezeichnete Schaltung ist insbesondere für ein als Starterbatterie ausgebildetes Energiespeicherelement 2 ausgebildet, mit dem Ziel, die eingesetzten Akkuzellen zu keinem Zeitpunkt außerhalb des vorgegebenen Arbeitsbereichs zu betreiben. Zu diesem Zweck werden Betriebskenngrößen wie Spannung, Strom, Temperatur der Energiespeichervorrichtung 1 oder einzelner Energiespeicherzellen oder Gruppen/Reihen von Energiespeicherzellen, sowie mechanische Belastung, die Gasatmosphäre oder der Standort der Energiespeichervorrichtung 1 durch die Datenerzeugungseinheit 4 erfasst und in entsprechende Digitaldaten umgesetzt. Darüber hinaus können sämtliche Schwellwerte frei programmiert werden, so dass die Trennvorrichtung auf die spezifische Anwendung bzw. das Verhalten des Fahrzeugs und dessen Batterieregelung angepasst werden kann. Ferner können die aus den im Betrieb gemessenen Grenzwerten ermittelten Daten verwendet werden, um die Trennvorrichtung adaptiv zu programmieren bzw. sich selbst anzulernen. Darüber hinaus können die Schwellwerte über Fahrzeug spezifisch hinterlegte Kennlinie nachträglich aufgespielt werden, so dass sicher gestellt werden kann, dass die Trennvorrichtung mit der vorhandenen Batterieregelung korrespondiert. Das Aufspielen der Daten kann z.b. via CAN/LIN-bus oder drahtlos via Bluetooth über ein Smartphone/Tablet erfolgen.

Diese "intelligente Autobatterie" umfasst folgende Komponenten/Merkmale:

### 1.) Lastschalter bzw. Trennvorrichtung 3

Die Trennvorrichtung 3 ist ein elektronischer Hochleistungsschalter auf MOSFET Basis, der für niedrige Spannungen im Bereich von 9V bis 16V und hohe Ströme bis 200 A Dauerstrom und 1200A Spitze ausgelegt ist.

Um die Wärmeentwicklung hierbei möglichst gering zu halten, werden die Leistungsströme direkt über Formteile 3b in Gestalt von Stanzbiegeteilen aus Kupfer oder Messing übertragen, ohne dass diese über eine normale Platine 3a geführt werden müssen. Die Schaltung besteht dabei aus einer Kombination einer normalen zweilagigen Platine 3a auf der die Steuerungselektronik implementiert ist und mehreren Formteile 3b, die den hohen Strom übertragen und die elektronischen Schalter (MOSFETs) anbinden. Durch diese Kombination kann auf spezielle und teure Platinentechnologie, wie z.B. Dickschichtplatinen, oder Kupferinlays verzichtet werden und extrem leistungsfähige Schalter sehr kostengünstig, klein und leicht realisiert werden.

### 2.) Fernwartung der Energiespeichervorrichtung 1:

In vorteilhafter Ausführung bietet die Energiespeichervorrichtung 1 dem Benutzer die Möglichkeit, sämtliche über die Datenerzeugungseinheit 4 erfassten Sensordaten in Echtzeit oder Historie über die Datenübertragungseinheit 6 in Gestalt z.B. einer WLAN/Bluetooth Schnittstelle mittels eines auf der Datenein-/ausgabevorrichtung 9 (z.B. mobiles Endgerät wie Smartphone oder Tablet) installierten Anwenderprogramms ("App") auszulesen und bei Bedarf auch grafisch darzustellen.

Hieraus ergibt sich nun die Möglichkeit, eine Fernwartung für sämtliche Produkte im Feld durchzuführen, um so folgende Szenaren effektiv zu erkennen und Gegenmaßnahmen einzuleiten bzw. den Benutzer z.B. per SMS zu Informieren bevor ein Schaden entsteht:
- fehlerhafte Benutzung der Energiespeichervorrichtung 1 (u.A. falsches Ladegerät)
- fehlerhafte Fahrzeugperipherie (u.A. defekter Lichtmaschinenregler)
- mangelhafte Einbausituation der Energiespeichervorrichtung 1 (u.A. zu nah am Motor oder Abgasanlage)
- fehlerhafte Akkuzellen (Spannungsabfall bzw. delta der Einzelzellen)

Darüber hinaus ist die Energiespeichervorrichtung 1 auch in der Lage, sich selbstständig dauerhaft (fehlerhafte Zellen) oder temporär (falsches Ladegerät) zu sperren und einen entsprechende Fehlercode an die APP des Benutzers zu senden.

Wenn beispielsweise die Datenerzeugungseinheit 4 über die erfassten Betriebskenngrößen der Energiespeichervorrichtung 1 einen Fehler der gesamten Energiespeichervorrichtung 1 erkennt bzw. ein entsprechendes Datensignal erzeugt, wird/werden über die Trennvorrichtung 3 eine Verbindung zwischen dem Energiespeicherelement 2 und einer Leistungsquelle 5 und/oder eine Verbindung zwischen dem Energiespeicherelement 2 und einem Leistungsempfänger 7 selektiv getrennt. Bei dieser "intelligenten Steuerung" ist eine Handlung des Benutzers oder eine Interaktion der Energiespeichervorrichtung 1 mit der Datenein-/ausgabevorrichtung 9 nicht erforderlich. Über die Datenübertragungseinheit 6 kann jedoch eine entsprechende Information an die Datenein-/ausgabevorrichtung 9 ausgegeben werden.

Wenn beispielsweise die Datenerzeugungseinheit 4 über die erfassten Betriebskenngrößen der Energiespeichervorrichtung 1 fehlerhafte Energiespeicherzellen erkennt bzw. ein entsprechendes Datensignal erzeugt, wird/werden über die Trennvorrichtung 3 eine Verbindung zwischen der oder den fehlerhaften Energiespeicherzellen und einer Leistungsquelle 5 und/oder eine Verbindung zwischen der oder den fehlerhaften Energiespeicherzellen und einem Leistungsempfänger 7 selektiv getrennt, während eine Verbindung zwischen der oder den funktionsfähigen Energiespeicherzellen und der Leistungsquelle 5 und/oder eine Verbindung zwischen der oder den funktionsfähigen Energiespeicherzellen und dem Leistungsempfänger 7 hergestellt oder aufrecht erhalten wird. Auch bei dieser "intelligenten Steuerung" ist eine Handlung des Benutzers oder eine Interaktion der Energiespeichervorrichtung 1 mit der Datenein-/ausgabevorrichtung 9 nicht erforderlich, wobei aber natürlich auch eine entsprechende Information an die Datenein-/ausgabevorrichtung 9 ausgegeben werden kann.

Über die Schnittstelle können sämtliche Energiespeichervorrichtungen 1 darüber hinaus im Umkreis von ca. 10m, beispielsweise durch BLE - Bluetooth Low Energy - je nach Art der Bluetooth-Leistung auch weiter, ausgelesen und aktiviert/deaktiviert werden, was z.B. beim Auslesen mehrerer Anwendungen bzw. Fahrzeugen von Vorteil sein kann.

### 3.) Diebstahlfunktion über wireless Schnittstelle

Hierzulande werden zahlreiche Fahrzeuge heutzutage über sogenannte Sniffer gänzlich ohne Werkzeug entwendet, in dem der Code der Funkfernbedienung mitgescannt wird oder einfach aufgebrochen und fremd gestartet wird.

Über die Datenübertragungseinheit 6 kann per Datenein-/ausgabevorrichtung 9 beispielsweise eine passwortgeschützte "Wegfahrsperre" aktiviert werden, über welche die Verbraucher/Sensoren des Fahrzeugs im Stand zwar dauerhaft mit Energie versorgt werden, beim Startvorgang aber sperren. Die "Wegfahrsperre" kann wahlweise aktiviert oder deaktiviert werden.

### 4.) Schutzfunktion bei Kälte / Wärme

Im Gegensatz zu herkömmlichen KFZ-Starterbatterien generieren Lithium-Eisen Akkus unter Last ihr eigenes Wärmefeld, so dass diese auch bei tiefen Temperaturen zuverlässig starten, wenn kurz vor dem Startvorgang entsprechend Energie entnommen wird. Diese Energieentnahme kann über Verbraucher im Bordnetz oder interne Entladung über Widerstände erfolgen.

Über den oben beschriebenen Ansatz kann die Energiespeichervorrichtung 1 bereits vor (via APP) oder beim (über Spannungsspitze an der ZB) Öffnen des Fahrzeugs aktiviert werden, so dass kurz nach dem Einsteigen auch im Winter stets direkt die volle Startleistung zur Verfügung steht - bis dahin wird z.B. für eine hohe Energieentnahme (Startvorgang) dauerhaft gesperrt.

Dadurch werden die Akkuzellen bei tiefen Temperaturen (< 10°C) signifikant weniger belastet werden als ohne vorangehende Erwärmung, was die Lebensdauer/Zyklenzahl erhöht.

Ebenso kann effektiv vor Wärme bzw. Überhitzung geschützt bzw. abgeschaltet werden, was einem "thermal runaway" vorbeugt (üblicher Anwendungsfall eines BMS bei Speicherbatterien).

### 5.) Schutzfunktion bei Überlast

Durch eine integrierte Sicherung können die Akkuzellen aktiv gegen Kurzschluss geschützt werden (üblicher Anwendungsfall eines BMS bei Speicherbatterien).

In der beschriebenen Ausführung der Energiespeichervorrichtung 1 wird die Strommessung jedoch zur Diagnose verwendet, um die Akkuzellen zusätzlich vor Überlast zu schützen:
a.) Dauerstrom zu hoch (zu viele Verbraucher oder Schaden an der LIMA) --> Trennen über erhöhten Messwert am Temperatursensor
b.) Startstrom zu hoch (Starterbatterie unterdimensioniert oder Anlasser defekt/fest) --> Trennen über erhöhten Messwert bei der Strommessung

### 6.) Integrierte Strommessung

Über den Spannungsabfall an den Schaltungen (MOSFETs) oder exakter über einen zusätzlichen Messwiderstand (gemeinhin "Shunt") kann der Strom in beide Richtungen (in Laderichtung bzw. von der Leistungsquelle 5 zum Energiespeicherelement 2 und in Entladerichtung bzw. vom Energiespeicherelement 2 zu dem Leistungsempfänger 7) näherungsweise in Echtzeit aufgezeichnet werden, was wiederum ermöglicht, den Ladezustand der Akkuzellen jederzeit via Datenein-/ausgabevorrichtung 9 einzusehen. Der so ermittelte exakte Ladezustand der Akkuzellen (gemeinhin "SOC" (State Of Charge)) gibt Aufschluss über die verbleibende Restkapazität. Ferner kann über einen Messwiderstand exakt der aktuell entnommene Nennstrom, sowie auch der Ruhestrom der im Stand aktiven Verbraucher/Fahrzeugperipherie ermittelt werden, wodurch eine hinreichend genaue Restlaufzeit bzw. Standzeit der Akkuzellen ermittelt und über die Datenübertragungseinheit ausgegeben werden kann.

### 7.) Vernetzung von Energiespeichervorrichtungen 1 untereinander

Die bestehenden Einheiten der Energiespeichervorrichtung 1 sind für 12V oder 16V Systeme ausgelegt, können aber auch in Reihenschaltung betrieben werden.

Damit alle Einheiten in einem Verbund auf demselben Niveau arbeiten, können diese über die jeweilige Datenübertragungseinheiten 6 untereinander aktiv kommunizieren und so Fehler effektiv erkennen.

In einer weiter gehenden Anwendung kann z.B. die Starterbatterie eines Wohnmobils mit der Energiespeichervorrichtung 1 kommunizieren und so möglichst intelligent Reserven bereitstellen.

### Bezugszeichenliste

- 1: Energiespeichervorrichtung
- 2: Energiespeicherelement
- 3: Trennvorrichtung
- 3a: Platine
- 3b: Formteil
- 3c: Bodenplatte
- 3d: Schalter (zwischen Energiespeicherelement und Leistungsquelle)
- 3e: Schalter (zwischen Energiespeicherelement und Leistungsempfänger)
- 4: Datenerzeugungseinheit
- 5: Leistungsquelle
- 6: Datenübertragungseinheit
- 7: Leistungsempfänger
- 8: Gehäuse
- 9: Datenein-/ausgabevorrichtung
- 10: Deckel
- 12: Bodenplatte
- 14: Schaum
- 16: Kabelanordnung
- 18: Pole
- 20: Druckausgleichsventil
- 22: Symbol
- 28: Vorrichtung zur Erzeugung eines Spannungsabfalls
- 30: Vorrichtung zur Erfassung elektrischer Ströme

## Patentansprüche

1. Energiespeichervorrichtung (1), insbesondere für den Anlasser eines Verbrennungsmotors, umfassend: wenigstens ein Energiespeicherelement (2), eine Datenerzeugungseinheit (4) zur Erfassung von Betriebskenngrößen des Energiespeicherelements (2) der Energiespeichervorrichtung (1) und zur Erzeugung entsprechender Daten, wobei die Betriebskenngrößen des Energiespeicherelements (2) wenigstens den elektrischen Strom und/oder die elektrische Spannung des Energiespeicherelements (2) umfassen, wenigstens eine Trennvorrichtung (3) zur reversiblen Trennung einer elektrisch leitenden Verbindung zwischen dem Energiespeicherelement (2) und einer Leistungsquelle (5) und/oder einer elektrisch leitenden Verbindung zwischen dem Energiespeicherelement (2) und einem Leistungsempfänger (7), und eine Datenübertragungseinheit (6) zur Datenübertragung zwischen der Datenerzeugungseinheit (4) und einer Datenein-/ausgabevorrichtung (9) sowie zwischen der Datenein-/ausgabevorrichtung (9) und der Trennvorrichtung (3), wobei die Datenein-/ausgabevorrichtung (9) ein Smartphone, ein Tablet oder ein Bordcomputer eines Fahrzeugs mit Bildschirm und Eingabeelementen ist, wobei die Trennvorrichtung (3) sowohl in Abhängigkeit von Daten betätigbar ist, die von der Datenerzeugungseinheit (4) unmittelbar an die Trennvorrichtung (3) übermittelt werden, als auch in Abhängigkeit von Daten, die von der Datenübertragungseinheit (6) an die Trennvorrichtung (3) übermittelt werden, und die Datenein-/ausgabevorrichtung (9) ausgebildet ist, die von der Datenerzeugungseinheit (4) erfassten Betriebskenngrößen auszulesen, wobei die Energiespeichervorrichtung (1) ein Gewicht im Bereich von 0,5 bis 5 kg, eine Kapazität im Bereich von 30 bis 1000 Wh und eine Nominalspannung im Bereich von 5 bis 24 V aufweist, wobei das Energiespeicherelement (2) in einem Gehäuse (8) aufgenommen ist, wobei ein Druckausgleich im Gehäuse (8) über eine in einem Gehäusedeckel integrierte Membran realisiert wird, wobei die Membran so ausgestaltet ist, dass diese sich bei einer Temperatur über 100°C öffnet oder auflöst und so den Luftdurchsatz zusätzlich erhöht.

2. Energiespeichervorrichtung (1) nach Anspruch 1, **dadurch gekennzeichnet, dass** die Energiespeichervorrichtung (1) das folgende Merkmal aufweist:
Die Energiespeichervorrichtung (1) erzeugt einen maximalen Entladungsstrom im Bereich von 200 bis 2000 A.

3. Energiespeichervorrichtung (1) nach einem der vorangehenden Ansprüche, **dadurch gekennzeichnet, dass** das Energiespeicherelement (2) das folgende Merkmal aufweist:
Das Energiespeicherelement (2) umfasst eine oder mehrere Energiespeicherzellen.

4. Energiespeichervorrichtung (1) nach einem der vorangehenden Ansprüche, **dadurch gekennzeichnet, dass** die Trennvorrichtung (3) das folgende Merkmal aufweist:
Die Trennvorrichtung (3) umfasst wenigstens einen elektronischen Schalter (3d, 3e) zur reversiblen Trennung einer elektrisch leitenden Verbindung zwischen dem Energiespeicherelement (2) und einer Leistungsquelle (5) und/oder einer elektrisch leitenden Verbindung zwischen dem Energiespeicherelement (2) und einem Leistungsempfänger (7).

5. Energiespeichervorrichtung nach einem der vorangehenden Ansprüche, **dadurch gekennzeichnet, dass** die Datenerzeugungseinheit (4) das folgende Merkmal aufweist:
Die Datenerzeugungseinheit (4) ist eingerichtet, wenigstens eine der folgenden weiteren Betriebskenngrößen der Energiespeichervorrichtung (1) zu erfassen und entsprechende Daten zu erzeugen:
i. Die Temperatur des Energiespeicherelements (2).
ii. Den Druck innerhalb oder in der Umgebung der Energiespeichervorrichtung (1).
iii. Den Feuchtigkeitsgehalt innerhalb oder in der Umgebung der Energiespeichervorrichtung (1).
iv. Die Gaszusammensetzung innerhalb oder in der Umgebung der Energiespeichervorrichtung (1).
v. Eine Beschleunigung der Energiespeichervorrichtung (1).
vi. Einen Standort der Energiespeichervorrichtung (1).

6. Energiespeichervorrichtung nach einem der vorangehenden Ansprüche, **dadurch gekennzeichnet, dass** die Datenübertragungseinheit (6) das folgende Merkmal aufweist:
Die Datenübertragungseinheit (6) ist zur kontaktlosen Signal- und/oder Energieübertragung eingerichtet.

7. Energiespeichervorrichtung (1) nach einem der vorangehenden Ansprüche, **dadurch gekennzeichnet, dass** die Datenerzeugungseinheit (4) zwischen dem Energiespeicherelement (2) und einer Gehäusewand angeordnet ist.

8. Energiespeichervorrichtung (1) nach einem der vorangehenden Ansprüche, **dadurch gekennzeichnet, dass** die Trennvorrichtung (3) separat von dem Energiespeicherelement (2) ausgebildet und/oder beabstandet von dem Energiespeicherelement (2) angeordnet ist und/oder wobei die Trennvorrichtung (3) in der Energiespeichervorrichtung (1) integriert ist.

9. Kraftfahrzeug mit einem Verbrennungsmotor, einem Anlasser sowie einer Energiespeichervorrichtung (1) nach einem der Ansprüche 1 bis 8.

10. Überwachungssystem mit wenigstens einer Energiespeichervorrichtung (1) nach Anspruch 1 bis 8 und einer Datenein-/ausgabevorrichtung (9) zum Datenaustausch mit der Datenerzeugungseinheit (6) der Energiespeichervorrichtung (1).

11. Verwendung einer Energiespeichervorrichtung nach einem der Ansprüche 1 bis 8 als Energiespeichervorrichtung für Kraftfahrzeuge.

## Claims

1. Energy storage device (1), in particular for the starter of an internal combustion engine, comprising: at least one energy storage element (2), a data generating unit (4) for acquiring operating parameters of said energy storage element (2) of said energy storage device (1) and generating corresponding data, where said operating parameters of said energy storage element (2) include at least the electrical current and/or the electrical voltage of said energy storage element (2), at least one separating device (3) for reversibly separating an electrically conductive connection between said energy storage element (2) and a power source (5) and/or an electrically conductive connection between said energy storage element (2) and a power receiver (7), and a data transmitting unit (6) for transmitting data between said data generating unit (4) and a data input/output device (9) and between said data input/output device (9) and said separating device (3), where said data input/output device (9) is a smartphone, a tablet or an on-board computer of a vehicle with a screen and input elements, where said separating device (3) can be actuated both depending on data which is transmitted directly from said data generating unit (4) to said separating device (3) and depending on data which is transmitted from said data transmitting unit (6) to said separating device (3), and said data input/output device (9) is configured read the operational parameters generated by said data generating device (4), wherein said energy storage device (1) has a weight in the range from 0.5 to 5 kg, a capacity in the range from 30 to 1000 Wh and a nominal voltage in the range from 5 to 24 V, wherein said energy storage element (2) is accommodated in a casing (8), where pressure equalization in said casing (8) is realized by way of a membrane integrated into a casing cover, where said membrane is configured such that it opens or disintegrates at a temperature above 100 °C and thus additionally increases the air throughput.

2. Energy storage device (1) according to claim 1, **characterized in that** said energy storage device (1) comprises the following feature:
Said energy storage device (1) generates a maximum discharge current in the range from 200 to 2000 A.

3. Energy storage device (1) according to one of the preceding claims, **characterized in that** said energy storage element (2) comprises the following feature:
Said energy storage element (2) comprises one or more energy storage cells.

4. Energy storage device (1) according to one of the preceding claims, **characterized in that** said separating device (3) comprises the following feature:
Said separating device (3) comprises at least one electronic switch (3d, 3e) for reversibly separating an electrically conductive connection between said energy storage element (2) and a power source (5) and/or an electrically conductive connection between said energy storage element (2) and a power receiver (7).

5. Energy storage device according to one of the preceding claims, **characterized in that** said data generating unit (4) comprises the following feature:
Said data generating unit (4) is configured to acquire at least one of the following operating parameters of said energy storage device (1) and to generate corresponding data:
i. The temperature of said energy storage element (2).
ii. The pressure within or in the environment of said energy storage device (1).
iii. The moisture within or in the environment of said energy storage device (1).
iv. The gas composition within or in the environment of said energy storage device (1).
v. Acceleration of said energy storage device (1).
vi. Location of said energy storage device (1).

6. Energy storage device according to one of the preceding claims, **characterized in that** said data transmitting unit (6) comprises the following feature:
Said data transmitting unit (6) is configured for contactless signal and/or energy transmission.

7. Energy storage device (1) according to one of the preceding claims, **characterized in that** said data generating unit (4) is arranged between said energy storage element (2) and a casing wall.

8. Energy storage device (1) according to one of the preceding claims, **characterized in that** said separating device (3) is formed separately from said energy storage element (2) and/or is arranged spaced from said energy storage element (2) and/or where said separating device (3) is integrated into said energy storage device (1).

9. Motor vehicle with an internal combustion engine, a starter and an energy storage device (1) according to one of claims 1 to 8.

10. Monitoring system with at least one energy storage device (1) according to claim 1 to 8 and a data input/output device (9) for data exchange with said data generating unit (6) of said energy storage device (1).

11. Use of an energy storage device according to one of claims 1 to 8 as energy storage device for motor vehicles.

## Revendications

1. Dispositif de stockage d'énergie (1), en particulier pour le démarreur d'un moteur à combustion interne, comprenant : au moins un élément de stockage d'énergie (2), une unité de génération de données (4) permettant de collecter des grandeurs de fonctionnement de l'élément de stockage d'énergie (2) du dispositif de stockage d'énergie (1) et de générer des données correspondantes, dans lequel les grandeurs de fonctionnement de l'élément de stockage d'énergie (2) comprennent au moins l'intensité électrique et/ou la tension électrique de l'élément de stockage d'énergie (2), au moins un dispositif de déconnexion (3) permettant de déconnecter de manière réversible une connexion électriquement conductrice entre l'élément de stockage d'énergie (2) et une source de puissance (5) et/ou une connexion électriquement conductrice entre l'élément de stockage d'énergie (2) et un récepteur de puissance (7), et une unité de transmission de données (6) permettant de transmettre des données entre l'unité de génération de données (4) et un dispositif d'entrée/sortie de données (9) ainsi qu'entre le dispositif d'entrée/sortie de données (9) et le dispositif de déconnexion (3), dans lequel le dispositif d'entrée/sortie de données (9) est un smartphone, une tablette ou un ordinateur de bord d'un véhicule avec écran et éléments d'entrée, dans lequel le dispositif de déconnexion (3) peut être actionné en fonction de données transmises directement au dispositif de déconnexion (3) par l'unité de génération de données (4) ou en fonction de données transmises au dispositif de déconnexion (3) par l'unité de transmission de données (6), et le dispositif d'entrée/sortie de données (9) est conçu pour lire les grandeurs de fonctionnement collectées par l'unité de génération de données (4), dans lequel le dispositif de stockage d'énergie (1) présente un poids situé dans la plage comprise entre 0,5 et 5 kg, une capacité située dans la plage comprise entre 30 et 1000 Wh et une tension nominale située dans la plage comprise entre 5 et 24 V, dans lequel l'élément de stockage d'énergie (2) est accueilli dans un boîtier (8), dans lequel une compensation de pression est réalisée dans le boîtier (8) par l'intermédiaire d'une membrane intégrée dans un couvercle de boîtier, dans lequel la membrane est conçue de sorte qu'elle s'ouvre ou se dissout à une température supérieure à 100□ et augmente ainsi le débit d'air de manière supplémentaire.

2. Dispositif de stockage d'énergie (1) selon la revendication 1, **caractérisé en ce que** le dispositif de stockage d'énergie (1) présente la caractéristique ci-dessous :
le dispositif de stockage d'énergie (1) génère une intensité de décharge maximale située dans la plage comprise entre 200 et 2000 A.

3. Dispositif de stockage d'énergie (1) selon l'une quelconque des revendications précédentes, **caractérisé en ce que** l'élément de stockage d'énergie (2) présente la caractéristique ci-dessous :
l'élément de stockage d'énergie (2) comprend une ou plusieurs cellule(s) de stockage d'énergie.

4. Dispositif de stockage d'énergie (1) selon l'une quelconque des revendications précédentes, **caractérisé en ce que** le dispositif de déconnexion (3) présente la caractéristique ci-dessous :
le dispositif de déconnexion (3) comprend au moins un interrupteur électronique (3d, 3e) permettant de déconnecter de manière réversible une connexion électriquement conductrice entre l'élément de stockage d'énergie (2) et une source de puissance (5) et/ou une connexion électriquement conductrice entre l'élément de stockage d'énergie (2) et un récepteur de puissance (7).

5. Dispositif de stockage d'énergie (1) selon l'une quelconque des revendications précédentes, **caractérisé en ce que** l'unité de génération de données (4) présente la caractéristique ci-dessous :
l'unité de génération de données (4) est conçue pour collecter au moins une des autres grandeurs de fonctionnement ci-dessous du dispositif de stockage d'énergie (1) et pour générer des données correspondantes :
i. La température de l'élément de stockage d'énergie (2).
ii. La pression à l'intérieur ou à proximité du dispositif de stockage d'énergie (1).
iii. La pression à l'intérieur ou à proximité du dispositif de stockage d'énergie (1).
iv. La composition gazeuse à l'intérieur ou à proximité du dispositif de stockage d'énergie (1).
v. Une accélération du dispositif de stockage d'énergie (1).
vi. Un emplacement du dispositif de stockage d'énergie (1).

6. Dispositif de stockage d'énergie (1) selon l'une quelconque des revendications précédentes, **caractérisé en ce que** l'unité de transmission de données (6) présente la caractéristique ci-dessous :
L'unité de transmission de données (6) est conçue pour transmettre sans contact des signaux et/ou de l'énergie.

7. Dispositif de stockage d'énergie (1) selon l'une quelconque des revendications précédentes, **caractérisé en ce que** l'unité de génération de données (4) est agencée entre l'élément de stockage d'énergie (2) et une paroi de boîtier.

8. Dispositif de stockage d'énergie (1) selon l'une quelconque des revendications précédentes, **caractérisé en ce que** le dispositif de déconnexion (3) est réalisé séparément de l'élément de stockage d'énergie (2) et/ou est agencé à distance de l'élément de stockage d'énergie (2) et/ou dans lequel le dispositif de déconnexion (3) est intégré dans le dispositif de stockage d'énergie (1).

9. Véhicule automobile avec un moteur à combustion interne, un démarreur et un dispositif de stockage d'énergie (1) selon l'une quelconque des revendications 1 à 8.

10. Système de surveillance comprenant au moins un dispositif de stockage d'énergie (1) selon les revendications 1 à 8 et un dispositif d'entrée/sortie de données (9) permettant d'échanger des données avec l'unité de génération de données (6) du dispositif de stockage d'énergie (1).

11. Utilisation d'un dispositif de stockage d'énergie selon l'une quelconque des revendications 1 à 8 comme dispositif de stockage d'énergie pour des véhicules automobiles.
